# EUROPÄISCHE PATENTANMELDUNG

(11) **EP 3 366 639 A1**
(43) Veröffentlichungstag der Anmeldung: **29.08.2018**
(21) Anmeldenummer: 17158423.8
(22) Anmeldetag: 28.02.2017
(51) Int. Cl.: B82Y 10/00, H01B 1/02, H01L 21/027, H01L 21/033, H01L 21/308, H01L 51/00

(54) **VERFAHREN ZUR HERSTELLUNG STRUKTURIERTER SCHICHTEN**

(71) Anmelder: Evonik Degussa GmbH, 45128 Essen (DE)
(72) Erfinder: MEYER, Sebastian, 47058 Duisburg (DE); MERKULOV, Sonja, 45770 Marl (DE); PFEIFFER, Holger, 63457 Hanau (DE); RENNER, Gerhard, 64589 Stockstadt am Rhein (DE)

(57) **Zusammenfassung**

Die vorliegende Erfindung betrifft ein Verfahren zur Herstellung einer strukturierten Schicht umfassend die nachfolgenden Schritte in aufsteigender Reihenfolge:
i) Bereitstellen eines Substrats
ii) Aufbringen einer polymeren Opferschicht auf das Substrat
iii) Aufbringen einer anorganischen oder organisch-anorganischen Maskierungsschicht auf die Opferschicht
iv) Strukturierung der Maskierungsschicht durch Energiezufuhr
v) ggf. Ätzen der Opferschicht

Sie betrifft ferner die durch dieses Verfahren erhältliche oder erhaltene strukturierte Schicht.

Die vorliegende Erfindung betrifft außerdem ein Verfahren zur Herstellung eines beschichteten Substrats umfassend die Schritte i) bis v) in austeigender Reihenfolge sowie das durch dieses Verfahren erhältliche oder erhaltene beschichtete Substrat.

Die vorliegende Erfindung betrifft auch die Verwendung der strukturierten Schicht als Templat zur entsprechend strukturierten Deposition von Metallen.

## Beschreibung

Die vorliegende Erfindung betrifft ein Verfahren zur Herstellung einer strukturierten Schicht umfassend die nachfolgenden Schritte in aufsteigender Reihenfolge:
i) Bereitstellen eines Substrats
ii) Aufbringen einer polymeren Opferschicht auf das Substrat
iii) Aufbringen einer anorganischen oder organisch-anorganischen Maskierungsschicht auf die Opferschicht
iv) Strukturierung der Maskierungsschicht durch Energiezufuhr
v) ggf. Ätzen der Opferschicht

Sie betrifft ferner die durch dieses Verfahren erhältliche oder erhaltene strukturierte Schicht.

Die vorliegende Erfindung betrifft außerdem ein Verfahren zur Herstellung eines beschichteten Substrats umfassend die Schritte i) bis v) in austeigender Reihenfolge sowie das durch dieses Verfahren erhältliche oder erhaltene beschichtete Substrat.

Die vorliegende Erfindung betrifft auch die Verwendung der strukturierten Schicht als Templat zur entsprechend strukturierten Deposition von Metallen.

Strukturierte Schichten finden vielfache Verwendung als Template. Strukturierte Schichten mit ungeordneten Strukturen sind insbesondere zur Unterdrückung des in geordnet strukturierten Mehrlagenschichten bei Displayanwendungen auftretenden Moire Effektes von Interesse. Dünnschichtensystem für die kontrollierte aber ungeordnete Selbstorganisation von Kanälen mit Submikrometer-Auflösung sind jedoch in der Regel nur durch kostenintensive Vakuum-Beschichtungen, Maskier- und Ätzprozesse zu erzeugen.

C. F. Guo et al. beschreiben die Herstellung strukturierter Schichten mittels "Grain-Boundary Lithography" (C. F. Guo et al., Nat. Commun. 5:3121, 2014: "Highly stretchable and transparent nanomesh electrodes made by grain boundary lithography"). Nachteilig hierbei ist, dass die Deposition des 2-Lagen Dünnschicht-Systems ausschließlich über Vakuumprozesse erfolgt, was die Beschichtung von sehr großen Substraten erschwert. Weiterhin werden starke Ätzmittel wie Fluorwasserstoffsäure verwendet, die die Umwelt belasten und speziell geschultes Personal zur Herstellung erforderlich machen. Der beschriebene Strukturierungsprozess des Templates ist nicht auf gängige Polymersubstrate (PET, PEN, PI) übertragbar, da die Temperaturen 400°C überschreiten.

T. He et al. beschreiben die Herstellung strukturierter Schichten mittels "Elektrospinning" eines Polymers (T. He et al., ACS Nano, Vol.5, 4782-4789, 2014: "A transparent electrode based on a metal nanotrough network"). Nachteilig hierbei ist, dass die Deposition des Templates nur sehr unkontrolliert durch das Elektrospinning-Verfahren erfolgt. Eine gezielte Beeinflussung der Templatstruktur ist dabei erschwert. Das Verfahren ist im Vergleich zu großflächigen Depositionstechniken (z.B. Slot-Die) weniger gut skalierbar. Weiterhin eignet sich ein mit dem Verfahren hergestelltes Templat nur bedingt für einen Lift-Off Prozess, da durch die runde Faserform nach vollflächiger Deposition eines Funktionsmaterials keine Angriffsfläche bereitsteht.

Gao et al. beschreiben die Herstellung strukturierter Schichten mittels einer mit Polystyrol-Kugeln belegten Oberfläche (Gao et al., Nano Lett. 14, 2105-2110, 2014: "Uniform and Ordered Copper Nanomeshes by Microsphere Lithography for Transparent Electrodes"). Nachteilig hierbei ist, dass die Haftung des Templates ohne chemische Bindung erfolgt und leicht bei nachfolgender lösungsbasierter Deposition weggespült wird.

WO 2006/042519 A1 ("Method for producing submicron structures") beschreibt die Strukturierung eines 1-Schicht Templat-Systems. Nachteilig ist hierbei, dass die Rissbildung bis auf das Substrat erfolgt und ein temporärer Kanalschutz nicht möglich ist. Auch ein Unterätzen zum Kanalschutz zur nachfolgenden inversen Strukturierung mit einem Funktionsmaterial ist nicht möglich. Weiterhin ist die Rissbildung immer an die kritische Schichtdicke des verwendeten Templat-Materials bzw. des Ausdehnungskoeffizienten des verwendeten Substrates gebunden.

WO 2014/136039 A1 ("Composition, substrates and methods thereof") beschreibt die Maskierung eines partikulären Templats. Nachteilig ist hierbei, dass die Rissbildung eher "U"-förmig verläuft, d.h. ohne hohes Kanal-Aspekt-Verhältnis. Ein "Lift-Off" Schritt nach der Deposition weiterer Funktionsmaterialien ist somit erschwert, da eine stärkere Seitenflankenbedeckung stattfindet. Das partikuläre Templat lässt sich weniger gut lösungsbasiert über Depositionsverfahren (z.B. Slot-Die, Ink-Jet) verarbeiten, da Schlitz- oder Düsenverstopfungen durch Agglomeration der Partikel wahrscheinlich sind. Weiterhin hat eine partikuläre Templatschicht den Nachteil, dass diese üblicherweise nur eine geringere Adhäsion zum Substrat aufweist und dadurch bei einer nachfolgenden lösungsbasierten Deposition leicht weggespült werden kann. Ferner können abgelöste Partikel des Templates den Kanal verunreinigen und die Haftung und/oder elektrische Funktionalität weitere Funktionsmaterialien im Kanal negativ beeinflussen.

Aufgabe der vorliegenden Erfindung war es deshalb, ein Verfahren zur Herstellung einer strukturierten Schicht mit ungeordneten Strukturen bereitzustellen, welches die zuvor genannten Nachteile des Standes der Technik überwindet.

Diese Aufgabe wird erfindungsgemäß gelöst durch ein Verfahren zur Herstellung einer strukturierten Schicht umfassend die nachfolgenden Schritte in aufsteigender Reihenfolge:
i) Bereitstellen eines Substrats
ii) Aufbringen einer polymeren Opferschicht auf das Substrat
iii) Aufbringen einer anorganischen oder organisch-anorganischen Maskierungsschicht auf die Opferschicht
iv) Strukturierung der Maskierungsschicht durch Energiezufuhr
v) ggf. Ätzen der Opferschicht

Die Herstellung der strukturierten Schicht erfolgt vollständig aus der Flüssigphase mit einem mindestens zweilagigen Dünnschichtsystem und Energiezufuhr und ggf. durch chemische Reaktion zwischen und/oder nach den einzelnen Depositionsschritten. Die Funktionsschichten zur Erzeugung der strukturierten Schicht umfassen mindestens eine polymere Opferschicht und eine anorganische oder organisch-anorganische Maskierungsschicht, die auf ein Substrat aufgebracht werden.

In einer bevorzugten Ausgestaltung des erfindungsgemäßen Verfahrens ist das Substrat in Schritt i) ein Glas, eine Polymer-Folie oder ein Silizium-Wafer.

Die Opferschicht und/oder die Maskierungsschicht können über großflächige Roll-2-Roll-, Roll-2-Sheet-, oder Sheet-2-Sheet-Beschichtungsverfahren, aber auch über direkte Depositionstechniken nacheinander und wahlweise mit oder ohne Energiezufuhr abgeschieden werden. Die jeweilige Schicht kann auch zuerst vollflächig abgeschieden werden und später über andere Techniken (z.B. Nanoimprint, Laserablation) vorstrukturiert werden.

In einer bevorzugten Ausgestaltung des erfindungsgemäßen Verfahrens wird die Opferschicht und/oder die Maskierungsschicht durch ein Beschichtungsverfahren ausgewählt aus der Gruppe bestehend aus Slot-Die, Spray-Coating, Dip-Coating, Spin-Coating und Rod-Coating aufgebracht.

In einer alternativen bevorzugten Ausgestaltung des erfindungsgemäßen Verfahrens wird die Opferschicht und/oder die Maskierungsschicht durch ein Druckverfahren ausgewählt aus der Gruppe bestehend aus Ink-Jet, Reverse-Offset, Gravure-Offset, Siebdruck und Mikrokontaktdruck aufgebracht.

Die Formulierung zum Aufbringen der organischen Opferschicht umfasst mindestens ein Polymer gelöst in einem organischen Lösungsmittel.

In einer bevorzugten Ausgestaltung des erfindungsgemäßen Verfahrens wird in Schritt ii) eine Lösung eines Polymers, vorzugsweise Polymethylmethacrylat oder Polystyrol, in einem organischen Lösungsmittel, vorzugsweise Methylethylketon, Ethylbenzoat oder Butylacetat, auf das Substrat aufgebracht und das Lösungsmittel anschließend verdampft.

Die Formulierung zur Aufbringung der anorganischen oder organisch-anorganischen Maskierungsschicht enthält ein Metall-Alkoxid, Metall-Oxo-Alkoxid, ein Sol-Gel, oder ein vergleichbares anorganischen oder organisch-anorganischen Präkursor-System.

In einer bevorzugten Ausgestaltung des erfindungsgemäßen Verfahrens wird in Schritt iii) eine Lösung eines Metall-Alkoxids, vorzugsweise Titan(IV)-ethoxid, Aluminium(III)-isopropoxid oder Hafnium(IV)-ethoxid, oder eines Metall-Oxo-Alkoxids, vorzugsweise aufweisend Poly(polyalkylammonium) poly(µ-alkoxy)-µ₆-oxido-polyhedro-poly(chloridometalate) polyalkanol solvate mit C₁₋₁₀-Alkyl- bzw. Alkoxyresten, insbesondere Bis(alkylammonium) oligo(µ-alkoxy)-µ₆-oxido-polyhedro-hexakis(chloridometal) mit C₁₋₁₀-Alkyl- bzw. Alkoxyresten, wobei unter "metalate" oder "metal" die Metalle Indium, Gallium und/oder Zink aufgefasst werden, in einem organischen Lösungsmittel, vorzugsweise Essigsäure, Ethanol, Butoxyethanol oder Acetylaceton, auf die Opferschicht aufgebracht und das Lösungsmittel anschließend verdampft.

Ferner kann die Formulierung zur Aufbringung der anorganischen oder organisch-anorganischen Maskierungsschicht ein Polymer enthalten, um Entnetzungs- und Phasenseparationsphänomene in der Maskierungsschicht zu erzeugen oder zu verstärken. Die Beigabe des Polymers kann ferner zur Einstellung der rheologischen Eigenschaften (Viskosität, Oberflächenspannung, Scherverhalten) verwendet werden.

Die zuvor genannten Formulierungen können zusätzlich unterschiedliche Additive, wie Dispergieradditive (z.B. Tego Dispers^{®} der Evonik Industries), Verlaufadditive (z.B. Tego Flow^{®} der Evonik Industries), Gleitadditive (z.B. Tego Glide^{®} der Evonik Industries AG), und/oder Füllstoffe, wie Nanopartikel (z.B. Aerosil^{®} der Evonik Industries AG) enthalten, die die jeweilige Formulierung ergänzen, um die Rheologie an das jeweilige Depositionsverfahren anzupassen. Die Additive und Füllstoffe können ferner dazu verwendet werden, die Ausdehnungskoeffizienten, Depolymerisations-, Sublimations- bzw. Kondensations-temperaturen und die Farbgebung bzw. Lichtdurchlässigkeit der jeweiligen Funktionsschicht zu beeinflussen.

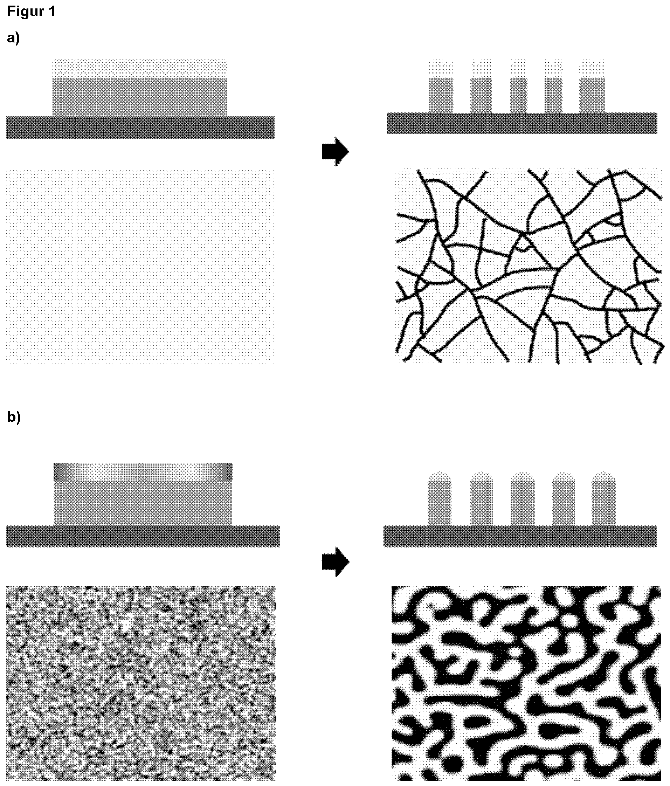

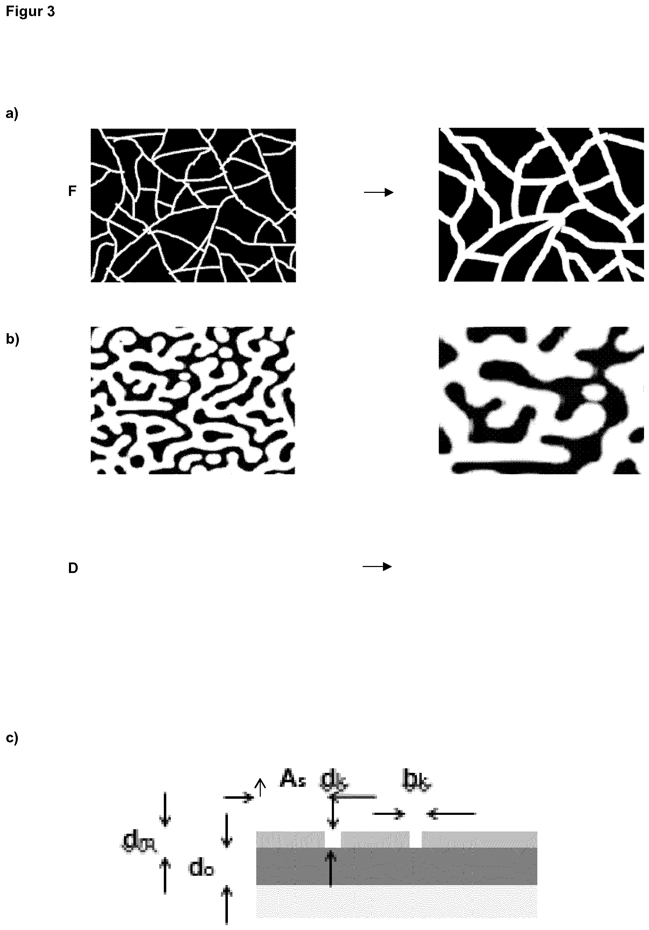

Die Strukturierung der Maskierungsschicht erfolgt durch Energiezufuhr, wodurch Selbstassemblierungsmechanismen indiziert werden. Die beiden wichtigsten sind in Abbildung 1 dargestellt. Die Kanalbildung kann dabei z.B. durch den Einfluss von externem Stress, unterschiedlichen Ausdehnungskoeffizienten und Rissbildung der Schichten (Figur 1a), der dem sogenannten Fracture-Ansatz, oder durch Entnetzungsphänomene, z.B. spinodale Entmischung oder Phasenseparation, dem sogenannten Dewetting-Ansatz, in der Maskierungsschicht (Figur 1b) erfolgen. Die Kanäle sind vollständig verbunden, aber ungeordnet über die gesamte Oberfläche verteilt und können über die Prozessparameter (Schichtdicke, Mischungsverhältnis und Energiezufuhr) hinsichtlich Kanalbreite, Schollenhöhe und Kanalmuster eingestellt werden; s. Figuren 1 und 3 c).

In einer bevorzugten Ausgestaltung des erfindungsgemäßen Verfahrens wird in Schritt iv) die Maskierungsschicht auf eine Temperatur unterhalb der Sublimationstemperatur des Polymers in der Opferschicht erhitzt.

Wenn der Temperschritt unterhalb der Sublimationstemperatur des Polymers in der Opferschicht erfolgt, verbleibt diese unter der Schollenstruktur. Die so erhaltene Zwischenschicht, welche organisches Material im Kanal und unter der Maskierungsschicht aufweist, hat Vorteile bei darauffolgenden Prozessschritten.

Um den Zugang zum Substrat zu öffnen, kann ausgehend von Prozessschritt iv) das organische Material durch unterschiedliche substraktive Methoden entfernt werden.

In einer bevorzugten Ausgestaltung des erfindungsgemäßen Verfahrens wird in Schritt v) die Opferschicht durch Kontakt mit einem Lösungsmittel, vorzugsweise Methylethylketon oder Aceton, durch Kontakt mit einer Säure oder Base, vorzugsweise Oxalsäure, Kaliumhydroxid, Natriumhydroxid, Ammoniumhydroxid, Tetramethylammoniumhydroxid, Lithiumhydroxid, Rubidiumhydroxid oder Natriumcarbonat, oder durch Kontakt mit UV-Strahlung oder Ozon/O₃ geätzt.

Eine selektive Entfernung der organischen Schicht ist auch möglich z.B. durch gezielte Deposition (Ink-Jet) von Lösungsmittel oder Säure/Base bzw. durch Maskierung mit einer Schattenmaske.

In einer alternativen bevorzugten Ausgestaltung des erfindungsgemäßen Verfahrens wird in Schritt iv) die Maskierungsschicht auf eine Temperatur oberhalb der Sublimationstemperatur des Polymers in der Opferschicht erhitzt.

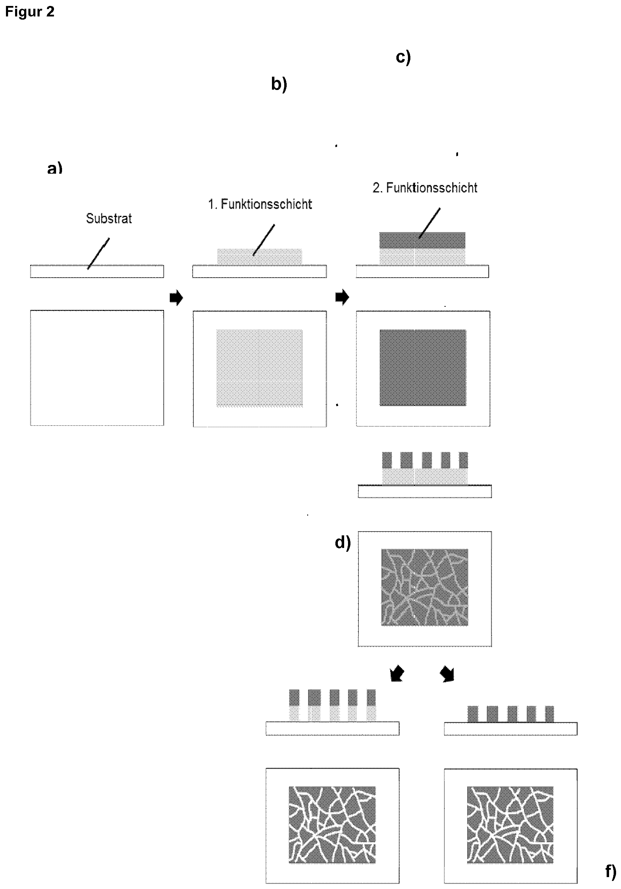

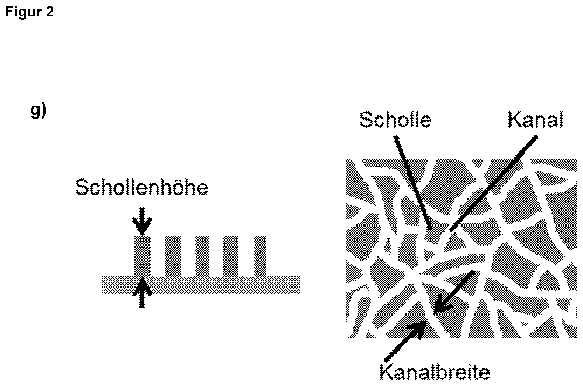

Findet der Temperschritt oberhalb der Sublimationstemperatur des Polymers in der Opferschicht statt, kann die in Figur 2 f) dargestellte anorganische/organisch-anorganische strukturierte Oberfläche erzeugt werden. Das organische Material aus der Opferschicht sublimiert dabei vollständig durch die entstandene Kanalstruktur.

Das in Figur 2 e) und Figur 2 f) schematische dargestellte Schichtsystem kann als Templat zur Deposition von Funktionsmaterialien (vorzugsweise Metalle, z.B. über die lösungsbasierte Deposition von metall-organischen Dekompositions-Präkursoren, Metall-Nanopartikel-Dispersionen oder Elektroplating) verwendet werden.

Mit dem hier beschriebenen erfindungsgemäßen Verfahren ist es möglich, einen kontrollierten Einfluss auf den selbstorganisierten Kanalbildungsprozess zu nehmen. Kanalbreite (bₖ), Schollenhöhe (dₖ), Schollenfläche (Aₛ) und Kanalstruktur sind über ein größeres Prozessfenster (Schichtdicke von Opfer- und Maskierungsschicht (dₒ) bzw. (dₘ) sowie Temperaturbehandlung) einstellbar. Über die in Figur 3 dargestellten Selbstassemblierungsmechanismen F und D ist eine sehr große Variationsmöglichkeit des Kanalmusters bzw. der Kanaldichte der Maskierungsschicht gegeben.

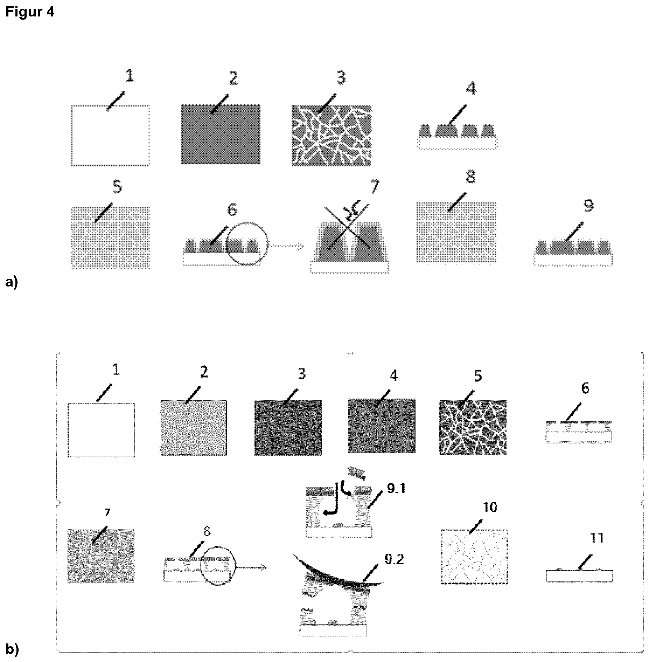

Die Kanalbildung ist dabei nicht zwingend an die kritische Schichtdicke des Materials oder den Ausdehnungskoeffizienten des Substrates gebunden. Die Kanäle, die in der anorganischen/organisch-anorganischen Maskierungsschicht entstehen weisen ein hohes Kanal-Aspekt-Verhältnis AV (Quotient aus Schichthöhe und Kanalbreite) auf und können durch die unter bestimmten Prozessbedingungen vorhandene Zwischenschicht (d.h. geschlossener Kanalzugang) unterätzt werden. Dadurch kann eine Seitenflankenbedeckung bei der lösungsbasierten Deposition von nachfolgend aufgebrachten Funktionsmaterialien unterdrückt bzw. auch vollständig verhindert werden (siehe Figur 4).

In einer bevorzugten Ausgestaltung des erfindungsgemäßen Verfahrens hat die anorganische/organisch-anorganische Maskierungsschicht eine deutlich geringere Schichtdicke als die organische Opferschicht, wodurch bei einem Unterätzen des organischen Materials im Kanal und beim anschließenden Entfernen der Templatstruktur Vorteile entstehen. Diese sind hauptsächlich auf das Unterätzen der Maskierungsschicht, auf den Bruch des Maskierungsschichtüberstandes und der Abreiß-Wahrscheinlichkeit der Opferschicht zurückzuführen. Die ersten beiden Effekte sind hauptsächlich beim "Lift-Off"- oder Auflöseprozess der Templatstruktur vorteilhaft, da hier jeweils eine höhere Wahrscheinlichkeit besteht, die Opferschicht angreifen zu können. Der dritte Effekt kann Delaminierungsprozesse begünstigen (Abbildung 4).

Ein effektiver Schutz vor z.B. Staub oder anderen Verunreinigungen in der Produktion bis kurz vor die eigentliche Deposition des Funktionsmaterials ist ebenfalls durch die Zwischenschicht möglich. Dadurch kann eine ideale Haftung gewährleistet und eine Kontamination des Funktionsmaterials verhindert werden.

In einer bevorzugten Ausgestaltung des erfindungsgemäßen Verfahrens entstehen durch Veresterung chemische Bindung zwischen organischer Opferschicht und Substrat. Dies führt zu einer besseren Beständigkeit gegen ein Ablösen des Templates bei lösungsbasierter Deposition von weiteren Funktionsschichten.

Die Strukturierung der Maskierungsschicht kann vollständig ohne starke Ätzmittel (z.B. Fluorwasserstoffsäure) und ohne hohe Prozess-Temperaturen (>200°C) durchgeführt werden und ist damit umweltschonend und nachhaltig. Die Opferschicht kann zur Senkung der Substratrauhigkeit beitragen und die Oberflächenenergie beeinflussen, wodurch eine homogenere Beschichtung der anorganischen/organisch-anorganischen Maskierungsschicht erhalten werden kann.

Gegenstand der vorliegenden Erfindung ist auch die strukturierte Schicht, erhältlich oder erhalten durch das hier beschriebene erfindungsgemäße Verfahren, wie beispielsweise in Figur 2 offenbart wird.

Gegenstand der vorliegenden Erfindung ist weiterhin ein Verfahren zur Herstellung eines beschichteten Substrats umfassend die hier beschriebenen Schritte i) bis v) in aufsteigender Reihenfolge sowie ein nach diesem Verfahren erhältliches oder erhaltenes beschichtetes Substrat, wie beispielsweise in Figur 2 offenbart wird.

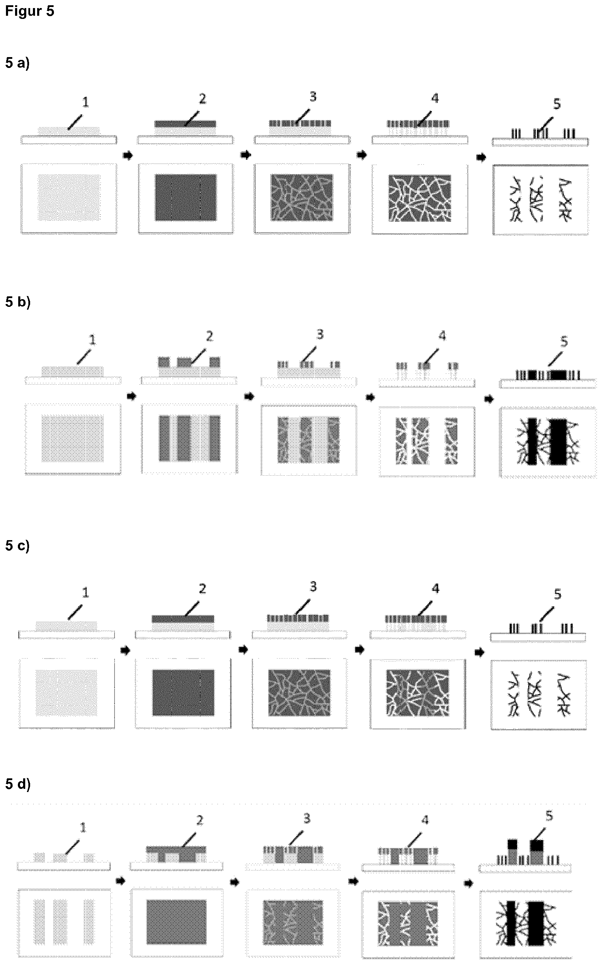

Gegenstand der vorliegenden Erfindung ist ferner die Verwendung einer erfindungsgemäßen strukturierten Schicht als Templat zur entsprechend strukturierten Deposition von Metallen, wie beispielsweise in den Figuren 4 a) und 4 b) sowie den Figuren 5 a) bis 5 d) offenbart wird.

### Beschreibung der Figuren:

**Figur 1** zeigt mögliche Selbstassemblierungsmechanismen zur Strukturierung der Maskierschicht: a) Fracture Ansatz; b) Dewetting Ansatz, wobei jeweils oben die Seitenansicht und unten die Aufsicht dargestellt ist.
**Figur 2** zeigt den schematischen Ablauf des erfindungsgemäßen Strukturierungsprozesses, wobei jeweils oben die Seitenansicht und direkt darunter die Aufsicht dargestellt ist:
   Figur 2 a) zeigt das Substrat, in 2 b) und c) erfolgt die lösungsbasierte gezielte oder vollflächige Deposition bzw. Auftragung der beiden Funktionsschichten, d.h. der Opferschicht in 2 b) sowie der Maskierungsschicht in 2 c) auf das Substrat mit den genannten Beschichtungsverfahren; Figur 2 d) gibt die strukturierte anorganische/organisch-anorganische Oberfläche mit organischem Material im Kanal, d.h. ohne Zugang zum Substrat, wieder; Figur 2 e) zeigt die strukturierte anorganische/organisch-anorganische Oberfläche nach Entfernung des organischen Materials im Kanal über genannte Methoden, d.h. mit Zugang zum Substrat; Figur 2 f) offenbart die struktuierte anorganische/organisch-anorganische Schicht ohne das darunter befindliche organische Material, welches beispielsweise mittels Sublimation als einer subtraktiven Methode durch die Kanalstruktur entfernt wurde; Figur 2 g) gibt die Definition der Strukturparameter anhand der in 2 f) hergestellten strukturierten Schicht wieder.
**Figur 3** zeigt die Einstellbarkeit der Maskierungsschichtstruktur über die beiden angenommenen Selbstassemblierungsmechanismen, wobei 3 a) den Fracture Ansatz F und 3 b) den Dewetting Ansatz D darstellen, Figur 3 c) hingegen gibt schematisch die für den Kanalbildungsprozess charakterisierenden Parameter mit Kanalbreite (bₖ), Schollenhöhe (dₖ), Schollenfläche (Aₛ) sowie der Schichtdicke von Opfer- und Maskierungsschicht (dₐ) bzw. (dₘ) wieder.
**Figur 4** zeigt in 4 a) die Nachteile bei der Strukturierung mit einem 1-Lagen Templat: **1** in Figur 4 a) stellt die Aufsicht auf das Substrat dar, **2** auf das mit einer aufgetragenen Opferschicht behandelte Substrat, **3** das mit einer aufgetragenen Opferschicht behandelte Substrat nach erfolgter Selbstassemblierung und **4** die Seitenansicht von **3** mit der fertigen Templatstruktur. **5** in Figur 4a) zeigt die vollflächige Deposition des Funktionsmaterials in der Aufsicht, **6** in der Seitenansicht. **7** zeigt in der Seitansicht, dass ein Auflöseprozess und Lift-off dieser einlagigen Templatstruktur nicht möglich ist. **8** und **9** in Figur 4 a) geben die Auf- und Seitenansicht des nicht strukturierten Schichtsystems wieder.
   Figur 4 b) zeigt die Vorteile beim "Lift-Off"-Prozess mit der erfindungsgemäßen zweilagigen Templatstruktur im Vergleich zu einer einlagigen Templatstruktur:
   **1** in Figur 4 b) stellt die Aufsicht auf das Substrat dar, **2** auf das mit einer aufgetragenen Opferschicht behandelte Substrat, **3** auf das zusätzlich mit einer aufgetragenen Maskierungsschicht behandelte Substrat und **4** die Aufsicht auf das mit einem 2-Lagen Templat behandelte Substrat nach erfolgter Selbstassemblierung. **5** in Figur 4 b) gibt die Aufsicht nach erfolgtem Unterätzen, **6** die entsprechende Seitenansicht der fertigen Templatstruktur wieder. **7** stellt die vollflächige Deposition mit dem Funktionsmaterials in der Aufsicht, **8** entsprechend in der Seitenansicht auf der 2-lagigen Templatstruktur dar. **9.1** in Figur 4 b) offenbart die Entfernung der Templatstruktur mittels Auflöseprozess und Lift-off, **9.2** entsprechend mittels Tapeabriss. Weiter sind in Figur 4 b) in **10** die Aufsicht und in **11** die Seitenansicht der erfindungsgemäß hergestellten Netzwerkstruktur auf dem Substrat offenbart.
**Figur 5** zeigt Beispiele zur Herstellung von strukturierten Netzwerken mit einem Kanaltemplat und einem Funktionsmaterial. Oben ist jeweils die Seitenansicht, darunter die entsprechende Aufsicht der jeweils hergestellten strukturierten Netzwerke dargestellt.
   Eine Ausführungsform der Erfindung in Figur 5 a) offenbart die jeweils vollflächige Auftragung einer Opferschicht 1 und einer Maskierungsschicht 2 übereinander auf einem Substrat. Im Anschluss erfolgt vollflächig die Kanalerzeugung 3 durch Energiezufuhr. Das nachfolgende Kanalätzen 4 wird ebenfalls vollflächig durchgeführt mittels subtraktiver Technik. Danach erfolgt die selektive Deposition des Funktionsmaterials 5 mittels Digitaldruck und Lift-off.
   Eine weitere Ausführungsform der Erfindung in Figur 5 b) offenbart die vollflächige Auftragung einer Opferschicht 1 sowie die strukturierte Auftragung einer Maskierungsschicht 2 übereinander auf einem Substrat. Die Kanalerzeugung 3 im Anschluss erfolgt vollflächig durch Energiezufuhr, wobei die Kanäle nur in den mit der Maskierungsschicht strukturierten Bereichen gebildet werden. Das nachfolgende Kanalätzen 4 wird ebenfalls vollflächig durchgeführt mittels subtraktiver Technik. Die Deposition des Funktionsmaterials 5 erfolgt vollflächig mittels Lift-off.
   Eine weitere Ausführungsform der Erfindung in Figur 5 c) offenbart die jeweils vollflächige Auftragung einer Opferschicht 1 und einer Maskierungsschicht 2 übereinander auf einem Substrat. Im Anschluss erfolgt vollflächig die Kanalerzeugung 3 durch Energiezufuhr. Das nachfolgende Kanalätzen 4 wird selektiv, beispielsweise durch Digitaldruck oder Schattenmaske, ausgeführt mittels subtraktiver Technik. Die Deposition des Funktionsmaterials 5 erfolgt vollflächig mittels Lift-off.
   Eine weitere Ausführungsform der Erfindung in Figur 5 d) offenbart die strukturierte Auftragung einer Opferschicht 1 auf einem Substrat, so dass ein Teil der Substratoberfläche nicht mit der Opferschicht bedeckt ist. Die Auftragung der Maskierungsschicht 2 wird nun vollflächig ausgeführt, ebenso wie die Kanalerzeugung 3 durch Energiezufuhr im Anschluss. Das nachfolgende Kanalätzen 4 erfolgt vollflächig mittels subtraktiver Technik. Schließlich wird die Deposition des Funktionsmaterials vollflächig mittels Lift-off durchgeführt.
   Diese Ausführungsform der Erfindung in Figur 5 d) ermöglicht sowohl eine Deposition des Funktionsmaterials direkt auf der Substratoberfläche als auch auf der verbliebenen Maskierungsschicht. In den Ausführungsformen der Erfindung in den Figuren 5 a), 5 b) und 5c) befindet sich das Funktionsmaterial letzlich jeweils direkt auf der Substratoberfläche.

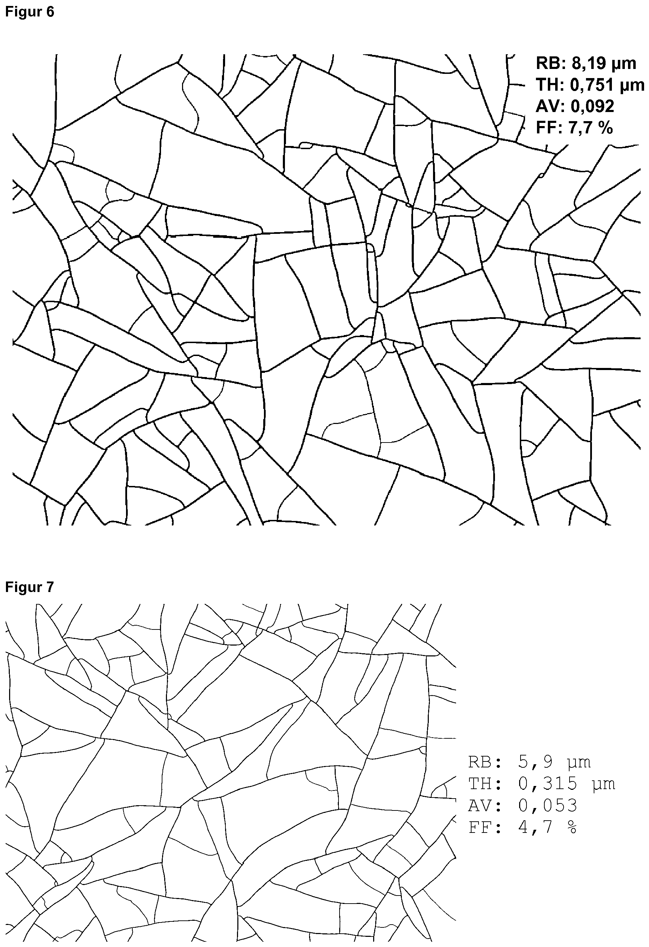

**Figur 6** zeigt ein Binärbild der Mikroskop-Aufnahme sowie ausgewertete Daten des Musters aus Versuch 1 der nachfolgenden Beispiele zur Auftragung einer Maskierungsschicht:
   Die mittlere Rissbreite (RB) wurde mit der Software "Image^{®}" und der Funktion "Thickness" des Plugins "Bone^{®}" ausgewertet. Der Riss-Füllfaktor (FF) wurde mit Hilfe eines Histogramms bestimmt und ist als das Verhältnis der Anzahl Risspixel zur Anzahl Gesamtpixel definiert. Die Bildgröße beträgt 2500 µm x 1875 (1280 px x 960 px) und setzt sich aus 4 Einzelaufnahmen zusammen. Die Risstiefe (RT) und Templathöhe (TH) wurden mittels Profilometrie und Ankratzen der Templatstruktur bestimmt. Durch Kenntnis der Templathöhe (TH) und Rissbreite (RB) kann ein Aspektverhältnis (AV = TH/RB) berechnet werden.
Die **Figuren 7** bis **31** sind den nachfolgenden Beispielen der Versuche 2 bis 25 zur Auftragung einer Maskierungsschicht unter **2.1)** Fracture-Ansatz sowie **2.2)** Dewetting-Ansatz zugeordnet. Sie offenbaren ebenfalls die Parameter mittlere Rissbreite (RB), Templathöhe (TH), Aspektverhältnis (AV = TH/RB) und Riss-Füllfaktor (FF).

iXsenic^{®} S und iXsenic^{®}S1201 sind eingetragene Marken der Evonik Industries AG.

iXsenic^{®} S weist Poly(polyalkylammonium) poly(µ-alkoxy)-µ₆-oxido-polyhedro-poly(chloridometalate) polyalkanol solvate auf, vorzugsweise Bis(alkylammonium) oligo(µ-alkoxy)-µ₆-oxido-polyhedro-hexakis(chloridometal), wobei unter "metalate" oder "metal" die Metalle Indium, Gallium und/oder Zink aufgefasst werden. Vorteilhafterweise kann unter iXsenic^{®} S die Verbindung [ln₆(µ₆-O)(µ₂-OR)₁₂Cl₆]²⁻ mit R = C₁₋₁₀-Alkyl offenbart sein.

iXsenic^{®}S1201 beinhaltet neben den bereits unter iXsenic^{®} S offenbarten Metallclusterverbindungen zusätzlich die für eine Beschichtungsformulierung notwendigen Lösungsmittel, welche Ethanol, 1-Methoxy-2-propanol, Tetrahydrofurfurylalkohol, 2-Methoxypropanol-1 aufweisen. Vorteilhafterweise stellt iXsenic^{®}S1201 eine gebrauchsfertige Slot-Die-Coating-Formulierung dar.

### Beispiele:

### 1) Aufbringen der Opferschicht über eine Polymerlösung (PMMA Stammlösung):

40 Gew.% Degalan^{®}LP 50/02 (Polymethylmethacrylat, PMMA) wird mit Hilfe eines Magnetrührers in Methylethylketon (MEK) vollständig gelöst. Um die Dicke der Opferschicht zu variieren, wird diese im Volumenverhältnis 1:2, 1:4 und 1:8 in MEK verdünnt und mittels Drehschleuderbeschichtung mit einer Drehgeschwindigkeit 1000 rpm, einer Drehbeschleunigung 1000 rpm/s und einer Drehzeit von 30s auf eine Oberfläche (vorgereinigtes Glas) aufgetragen. Danach folgt ein Temperaturschritt bei 130 °C für eine Minute auf einer Heizplatte. Die resultierende Schichtdicke beträgt 505 nm, 172 nm und 68 nm und wurde durch Ankratzen und mittels Profilometrie ermittelt.

### 2) Auftragen der Maskierungsschicht und Entfernung der organischen Schicht im Kanal je nach Schichtdicke und Ätzraten der jeweiligen Schichtsysteme:

Zur Kanalfreilegung wird im Folgenden entweder ein MEK Ätzschritt und ein anschließender Spülschritt mit entionisiertem Wasser (DI-Wasser) oder eine UV-Ozon-Behandlung (*184.9 nm und 253.7 nm)* durchgeführt. Die jeweils benötigte Zeit, um den Kanal zum Substrat freizulegen, richtet sich dabei nach der Risstiefe und der Schichthöhe. PMMA wird mit einer MEK-Ätzrate von 10,4 nm/s und einer UV-Ozon-Ätzrate von 12 nm/s entfernt.

### 2.1) Fracture-Ansatz über einen Metall-Alkoxid oder Oxo-Alkoxid Präkursor (Versuche 1 bis 24):

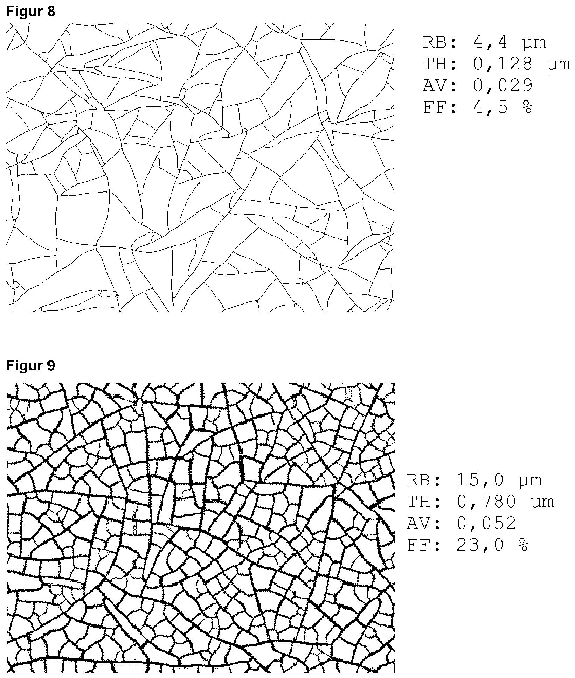

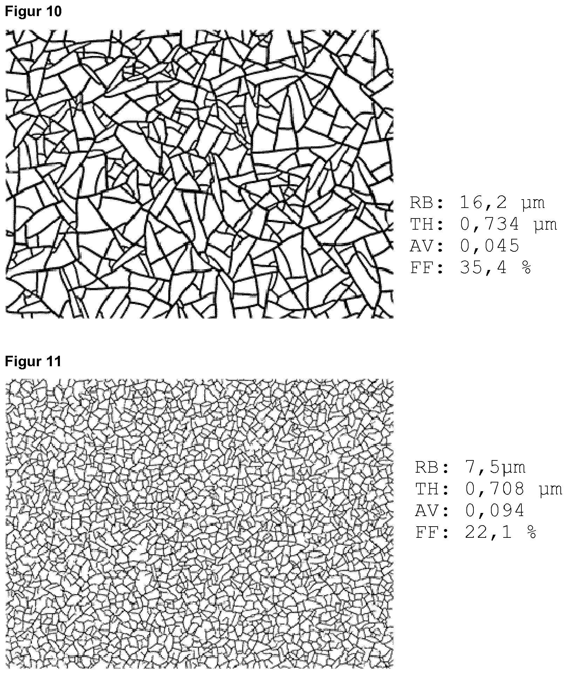

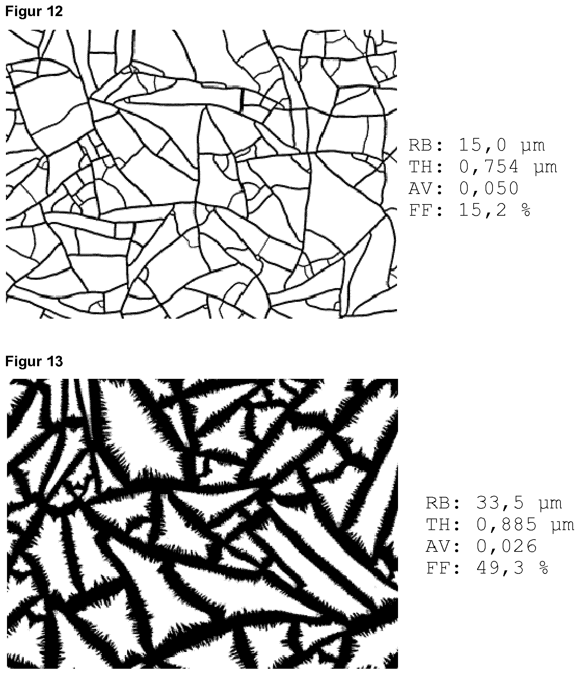

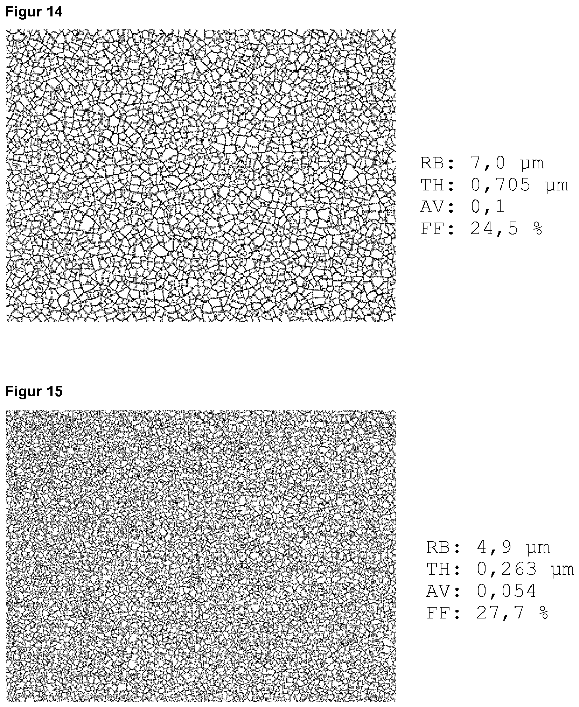

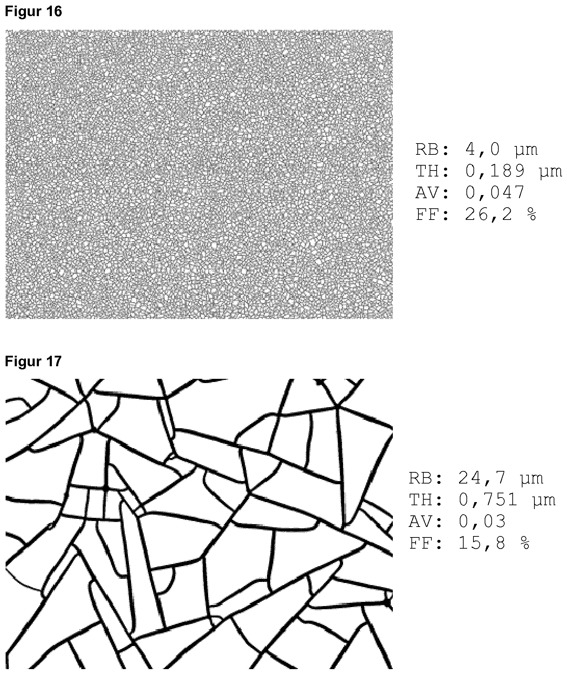

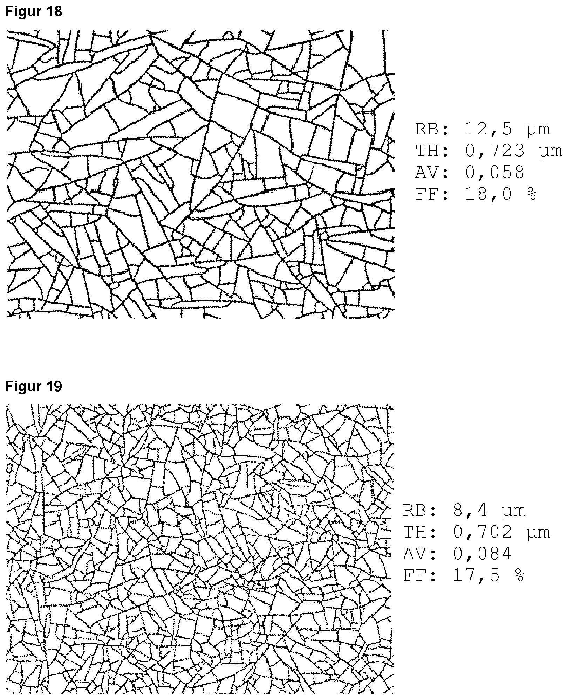

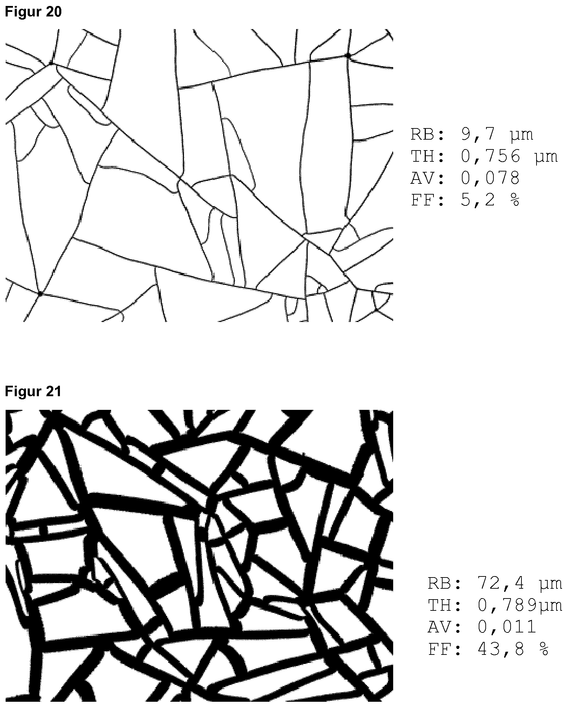

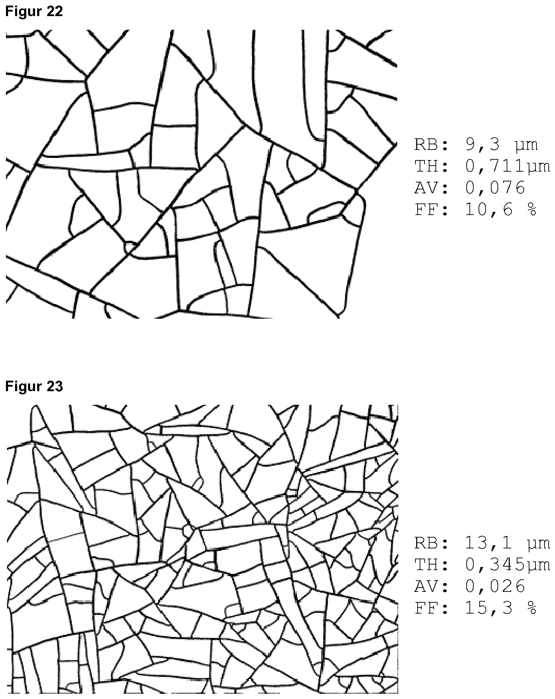

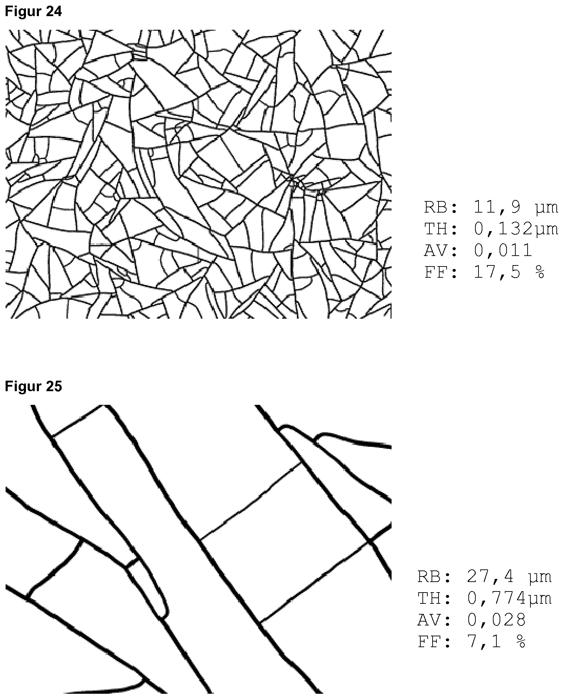

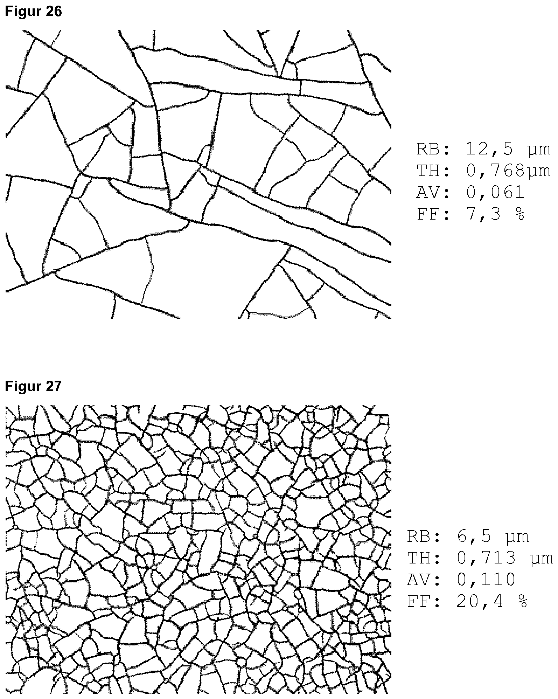

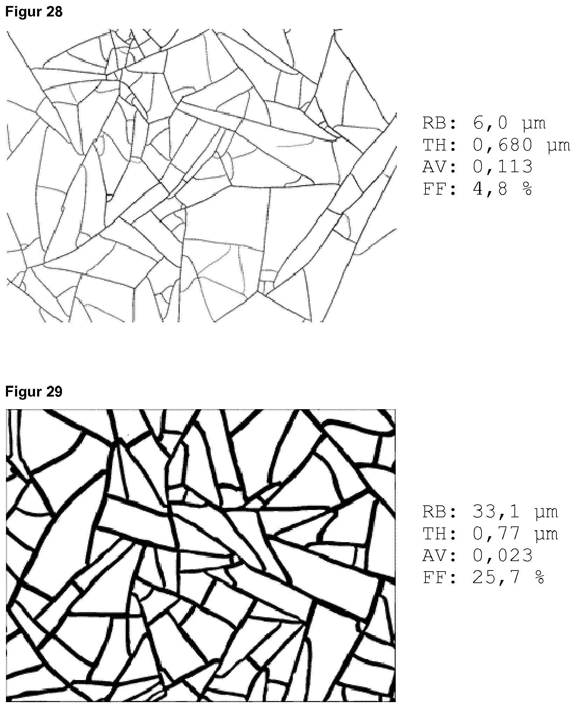

1. 6,3ml Titan(IV)-Ethoxid werden mit Hilfe eines Magnetrührers in 5ml Essigsäure und 50ml EtOH gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 130°C auf einer Heizplatte erzeugt. Zur Kanalfreilegung wird eine MEK Eintauchzeit von 38 s gewählt und die Probe anschließend für 10s mit DI-Wasser gespült und mit N₂ getrocknet.
   Die Auswertung der Probe mit den Parametern mittlere Rissbreite (RB), Templathöhe (TH), Aspektverhältnis (AV = TH/RB) und Riss-Füllfaktor (FF) ist in Figur 6 dargestellt.
2. 6,3ml Titan(IV)-Ethoxid werden mit Hilfe eines Magnetrührers in 5ml Essigsäure und 50ml EtOH gelöst und mittels Drehschleuderbeschichtung mit 3000 rpm, 3000 rpm/s, 30s auf die vorher abgeschiedene organische Opferschicht (PMMA Stammlösung 1:4 in MEK) aufgetragen. Im nächsten Schritt wird externer Stress im Dünnschichtsystem für 30 min bei 130°C auf einer Heizplatte erzeugt. Zur Kanalfreilegung wird eine MEK Eintauchzeit von 18 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 7 dargestellt.
3. 6,3ml Titan(IV)-Ethoxid werden mit Hilfe eines Magnetrührers in 5ml Essigsäure und 50ml EtOH gelöst und mittels Drehschleuderbeschichtung mit 3000 rpm, 3000 rpm/s, 30s auf die vorher abgeschiedene organische Opferschicht (PMMA Stammlösung 1:8 in MEK) aufgetragen. Im nächsten Schritt wird externer Stress im Dünnschichtsystem für 30 min bei 130°C auf einer Heizplatte erzeugt. Zur Kanalfreilegung wird eine MEK Eintauchzeit von 6 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 8 dargestellt.
4. 50 mg/ml Titan(IV)-Ethoxid werden in EtOH gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 34 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 9 dargestellt.
5. 16,67 mg/ml Titan(IV)-Ethoxid werden in EtOH gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 33 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 10 dargestellt.
6. 6,25 mg/ml Titan(IV)-Ethoxid werden in EtOH gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 35 s gewählt und die Probe anschließend für 10s mit DI-Wasser gespült und mit N₂ getrocknet.. Die Auswertung der Probe mit den Parametern mittlere Rissbreite (RB), Templathöhe (TH), Aspektverhältnis (AV = TH/RB) und Riss-Füllfaktor (FF) ist in Figur 11 dargestellt.
7. 50 mg/ml Titan(IV)-Ethoxid werden in EtOH gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 130°C auf einer Heizplatte erzeugt. Zur Kanalfreilegung wird eine MEK Eintauchzeit von 18 s gewählt und die Probe anschließend für 39 s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 12 dargestellt.
8. 50 mg/ml Titan(IV)-Ethoxid werden in EtOH gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 200°C auf einer Heizplatte erzeugt. Zur Kanalfreilegung wird eine MEK Eintauchzeit von 33 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 13 dargestellt.
9. 3,75g Hafnium(IV)-Ethoxid werden in 1,07 ml Acetylaceton und 50 ml EtOH gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 21 s gewählt und die Probe anschließend für 10 s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 14 dargestellt.
10. 3,75g Hafnium(IV)-Ethoxid werden in 1,07 ml Acetylaceton und 50 ml EtOH gelöst und mittels Drehschleuderbeschichtung mit 3000 rpm, 3000 rpm/s, 30s auf die vorher abgeschiedene organische Opferschicht (PMMA Stammlösung 1:4 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 5s gewählt und die Probe anschließend für 10 s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 15 dargestellt.
11. 3,75g Hafnium(IV)-Ethoxid werden in 1,07 ml Acetylaceton und 50 ml EtOH gelöst und mittels Drehschleuderbeschichtung mit 3000 rpm, 3000 rpm/s, 30s auf die vorher abgeschiedene organische Opferschicht (PMMA Stammlösung 1:8 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 5s gewählt und die Probe anschließend für 10 s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 16 dargestellt.
12. 50 mg/ml Hafnium(IV)-Ethoxid werden in EtOH gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 26 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 17 dargestellt.
13. 16,67 mg/ml Hafnium(IV)-Ethoxid werden in EtOH gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 31 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 18 dargestellt.
14. 6,25 mg/ml Hafnium(IV)-Ethoxid werden in EtOH gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 33 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 19 dargestellt.
15. 50 mg/ml Hafnium(IV)-Ethoxid werden in EtOH gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 130°C auf einer Heizplatte erzeugt. Zur Kanalfreilegung wird eine MEK Eintauchzeit von 38 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 20 dargestellt.
16. 50 mg/ml Hafnium(IV)-Ethoxid werden in EtOH gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 200°C auf einer Heizplatte erzeugt. Zur Kanalfreilegung wird eine MEK Eintauchzeit von 18 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 21 dargestellt.
17. iXsenic^{®}S1201 wird mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 52 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 22 dargestellt.
18. iXsenic^{®}S1201 wird mittels Drehschleuderbeschichtung mit 3000 rpm, 3000 rpm/s, 30s auf die vorher abgeschiedene organische Opferschicht (PMMA Stammlösung 1:4 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 19 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 23 dargestellt.
19. iXsenic^{®}S1201 wird mittels Drehschleuderbeschichtung mit 3000 rpm, 3000 rpm/s, 30s auf die vorher abgeschiedene organische Opferschicht (PMMA Stammlösung 1:8 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 6 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 24 dargestellt.
20. 50 mg/ml iXsenic^{®} S werden in 1-Methoxy-2-Propanol gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 13 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 25 dargestellt.
21. 16,67 mg/ml iXsenic^{®} S werden in 1-Methoxy-2-Propanol gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 20 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 26 dargestellt.
22. 6,25 mg/ml iXsenic^{®} S werden in 1-Methoxy-2-Propanol gelöst und mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 150°C auf einer Heizplatte erzeugt. Zur Kanalfreilegung wird eine MEK Eintauchzeit von 33 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 27 dargestellt.
23. iXsenic^{®}S1201 wird mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für erzeugt. Im nächsten Schritt wird externer Stress im Dünnschichtsystem für 30 min bei 130°C auf einer Heizplatte erzeugt. Zur Kanalfreilegung wird eine MEK Eintauchzeit von 45s gewählt und die Probe anschließend für 10 s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 28 dargestellt.
24. iXsenic^{®}S1201 wird mittels Drehschleuderbeschichtung mit 3000 rpm, 3000 rpm/s, 30s auf die vorher abgeschiedene organische Opferschicht (PMMA Stammlösung 1:2 in MEK) aufgetragen. Im nächsten Schritt wird externer Stress im Dünnschichtsystem für 30 min bei 200°C auf einer Heizplatte erzeugt. Zur Kanalfreilegung wird eine MEK Eintauchzeit von 30 s gewählt und die Probe anschließend für 10s mit DI-Wasser gespült und mit N₂ getrocknet. Die Auswertung der Probe mit den Parametern mittlere Rissbreite (RB), Templathöhe (TH), Aspektverhältnis (AV = TH/RB) und Riss-Füllfaktor (FF) ist in Figur 29 dargestellt.

### 2.2) Auftragen der Maskierungsschicht - Dewetting-Ansatz über einen Metall-Oxo-Alkoxid Präkursor (Versuch 25):

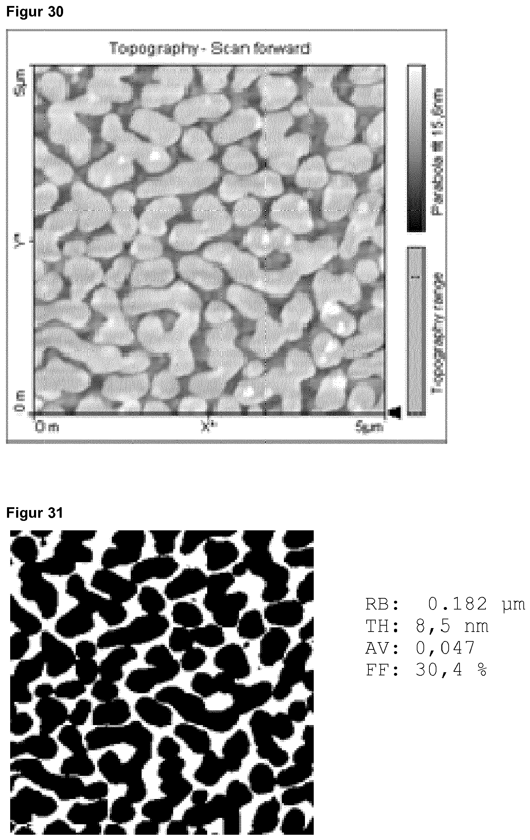

25. Über einen Metall-Oxo-Alkoxid Präkursor.
   iXsenic^{®}S1201 mit 28 Gew.% PMMA LP50/02 wird mittels Drehschleuderbeschichtung mit 2000 rpm, 2000 rpm/s, 30s auf die vorher abgeschiedene organische Opferschicht aufgetragen. Im nächsten Schritt wird das Substrat von 150 °C auf 350°C auf einer Heizplatte erhitzt.
   Die AFM (Atomic Force Microscopy) Messung (5 µm x 5 µm) ist in Figur 30 wiedergegeben. Die Auswertung der Probe mit den Parametern mittlere Rissbreite (RB), Templathöhe (TH), Aspektverhältnis (AV = TH/RB) und Riss-Füllfaktor (FF) ist in Figur 31 dargestellt.

### 3) Entfernung der organischen Schicht im Kanal (ausgehend von Prozessschritt 3 in Figur 2d) je nach Schichtdicke und Ätzraten der jeweilgen Schichtsysteme

I) Lösemittelkontakt über Dip-Coating, Slot-Die-Coating oder selektiv mittels Jet-Verfahren (Methylethylketon, Ethylbenzoat, Butylacetat oder Aceton)
II) mittels UV-Ozon Behandlung im Bereich 184.9 nm und 253.7 nm
III) Nasschemischer Ätzkontakt über Dip-Coating, Slot-Die-Coating oder selektiv mittels Jet-Verfahren (KOH, NaOH, LiOH, NH₄OH, Na₂CO₃, RbOH, Tetramethylammoniumhydroxid)
IV)Trockenätzen großflächig oder selektiv mit einer Schattenmaske
V) O₂ Plasmaveraschung
VI) CO₂ Snow Cleaning Methode

## Patentansprüche

1. Verfahren zur Herstellung einer strukturierten Schicht umfassend die nachfolgenden Schritte in aufsteigender Reihenfolge:
i) Bereitstellen eines Substrats
ii) Aufbringen einer polymeren Opferschicht auf das Substrat
iii) Aufbringen einer anorganischen oder organisch-anorganischen Maskierungsschicht auf die Opferschicht
iv) Strukturierung der Maskierungsschicht durch Energiezufuhr
v) ggf. Ätzen der Opferschicht

2. Verfahren nach Anspruch 1, **dadurch gekennzeichnet, dass** das Substrat in Schritt i) ein Glas, eine Polymer-Folie oder ein Silizium-Wafer ist.

3. Verfahren nach Anspruch 1 oder 2, **dadurch gekennzeichnet, dass** in Schritt ii) eine Lösung eines Polymers, vorzugsweise Polymethylmethacrylat oder Polystyrol, in einem organischen Lösungsmittel, vorzugsweise Methylethylketon, Ethylbenzoat oder Butylacetat, auf das Substrat aufgebracht und das Lösungsmittel anschließend verdampft wird.

4. Verfahren nach einem der Ansprüche 1 bis 3, **dadurch gekennzeichnet, dass** in Schritt iii) eine Lösung eines Metall-Alkoxids, vorzugsweise Titan(IV)-ethoxid oder Aluminium(III)-isopropoxid oder Hafnium(IV)-ethoxid, oder eines Metall-Oxo-Alkoxids, vorzugsweise aufweisend Poly(polyalkylammonium) poly(µ-alkoxy)-µ₆-oxido-polyhedro-poly(chloridometalate) polyalkanol solvate mit C₁₋₁₀-Alkyl- bzw. Alkoxyresten, insbesondere Bis(alkylammonium) oligo(µ-alkoxy)-µ₆-oxido-polyhedro-hexakis(chloridometal) mit C₁₋₁₀-Alkyl- bzw. Alkoxyresten, wobei unter "metalate" oder "metal" die Metalle Indium, Gallium und/oder Zink aufgefasst werden, in einem organischen Lösungsmittel, vorzugsweise Essigsäure, Ethanol, Butoxyethanol oder Acetylaceton, auf die Opferschicht aufgebracht und das Lösungsmittel anschließend verdampft wird.

5. Verfahren nach einem der Ansprüche 1 bis 4, **dadurch gekennzeichnet, dass** in Schritt iv) die Maskierungsschicht auf eine Temperatur oberhalb der Sublimationstemperatur des Polymers in der Opferschicht erhitzt wird.

6. Verfahren nach einem der Ansprüche 1 bis 4, **dadurch gekennzeichnet, dass** in Schritt iv) die Maskierungsschicht auf eine Temperatur unterhalb der Sublimationstemperatur des Polymers in der Opferschicht erhitzt wird.

7. Verfahren nach Anspruch 6, **dadurch gekennzeichnet, dass** in Schritt v) die Opferschicht durch Kontakt mit einem Lösungsmittel, vorzugsweise Methylethylketon oder Aceton, durch Kontakt mit einer Säure oder Base, vorzugsweise Oxalsäure, Kaliumhydroxid, Natriumhydroxid, Ammoniumhydroxid, Tetramethylammoniumhydroxid, Lithiumhydroxid, Rubidiumhydroxid oder Natriumcarbonat, oder durch Kontakt mit UV-Strahlung oder Ozon/O₃ geätzt wird.

8. Verfahren nach einem der Ansprüche 1 bis 7, **dadurch gekennzeichnet, dass** die Opferschicht und/oder die Maskierungsschicht durch ein Roll-2-Roll-, Roll-2-Sheet-, Sheet-2-Sheet-Beschichtungsverfahren oder durch ein Druckverfahren aufgebracht wird.

9. Verfahren nach Anspruch 8, **dadurch gekennzeichnet, dass** das Beschichtungsverfahren ausgewählt ist aus der Gruppe bestehend aus Slot-Die, Spray-Coating, Dip-Coating, Spin-Coating und Rod-Coating.

10. Verfahren nach Anspruch 8, **dadurch gekennzeichnet, dass** das Druckverfahren ausgewählt ist aus der Gruppe bestehend aus Ink-Jet, Reverse-Offset, Gravure-Offset, Siebdruck und Mikrokontaktdruck.

11. Strukturierte Schicht erhältlich oder erhalten durch ein Verfahren nach einem der Ansprüche 1 bis 10.

12. Verfahren zur Herstellung eines beschichteten Substrats umfassend die Schritte i) bis v) gemäß einem der Ansprüche 1 bis 10 in austeigender Reihenfolge.

13. Beschichtetes Substrat erhältlich oder erhalten durch ein Verfahren nach Anspruch 12.

14. Verwendung einer strukturierten Schicht nach Anspruch 11 als Templat zur entsprechend strukturierten Deposition von Metallen.
